Europäisches Patentamt

European Patent Office

Office européen des brevets

(11) Publication number: **0 066 950**
**B1**

(12) **EUROPEAN PATENT SPECIFICATION**

(45) Date of publication of patent specification: **11.12.85**

(51) Int. Cl.⁴: **H 02 H 7/00**, B 03 C 3/68

(21) Application number: **82302181.1**

(22) Date of filing: **28.04.82**

(54) **Method of protecting a thyristor switch of a pulse generator.**

(30) Priority: **21.05.81 GB 8115606**

(43) Date of publication of application:
**15.12.82 Bulletin 82/50**

(45) Publication of the grant of the patent:
**11.12.85 Bulletin 85/50**

(84) Designated Contracting States:
**BE CH DE FR GB IT LI LU NL SE**

(56) References cited:
**DE-A-3 015 198**
**DE-B-2 005 724**
**US-A-4 052 177**
**US-A-4 238 810**

(73) Proprietor: **F.L. Smidth & Co. A/S**
**77 Vigerslev Alle**
**DK-2500 Valby Copenhagen (DK)**

(72) Inventor: **Henriksen, Henrik**
**39-43, Industriparken**
**DK-2750 Ballerup Copenhagen (DK)**
Inventor: **Nielsen, Torben Glar**
**39-43, Industriparken**
**DK-2750 Ballerup Copenhagen (DK)**
Inventor: **Taarning, Claus Ebbe**
**39-43, Industriparken**
**DK-2750 Ballerup Copenhagen (DK)**

(74) Representative: **Brunner, Michael John et al**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to a method of protecting a thyristor switch element, coupled anti-parallel to a diode in an energy recovering pulse generator supplying an electrostatic precipitator, against damage from spark-overs in the precipitator during a period of pulse decay. Switch elements may include one or a number of thyristors. The use of thyristors in switch elements enables large charging currents to be applied to capacitive loads such as electrostatic precipitators.

An inherent problem in pulse energisation of a heavy capacitive load is the considerable amount of energy required for the repetitive charging of the load capacitance to the high pulse voltage level, whereas, only little energy is dissipated in the load. For reasons of economy, recovery of the energy stored in the capacitance itself during each pulse and not used, e.g. by corona discharge is, therefore, important in pulse energisation of heavy capacitive loads such as large precipitators. This problem has been solved by the energy conserving pulse system described in GB—A—1544105. The energy conservation is obtained by coupling a feed-back diode anti-parallel to the thyristor which starts the pulse when triggered.

The design criteria for the thyristors and diodes in the switch element are:

—hold-off voltage
—pulse width
—peak on-state current
—maximum rate of rise of current
—thyristor turn-off time

Particular attention has to be given to the problem of spark-overs occurring in the load. Experience shows that spark-overs will occur during the increase of the pulse voltage as well as during the pulse voltage decay. Obviously, the thyristors and diodes must be designed for the current and voltage values obtained during these conditions.

For spark-over during the pulse voltage decay special precautions must be taken to protect the thyristors. In the energy conserving pulse system described in GB—A—1544105 the pulse circuit current in the situation flows through the feed-back diode, while the thyristors are recovering their hold-off strength. While recovering, the thyristor pellet has an unevenly distributed conductivity. Consequently, the spark-over current will be concentrated across the thyristor in a few spots with high conductivity, and often therefore will destroy the thyristor pellet by current overload at these particular spots.

It is known to trigger a thyristor into conduction when it is subjected to an overload during its recovery phase, i.e. if it is forward biased before it has recovered. According to DE—A—2005724, the polarity of the bias of the thyristor is supervised, and when this polarity changes to negative, i.e. the thyristor is backward biased, a timer measuring out the recovery time is started, and an emergency triggering of the thyristor is released if the bias of the thyristor changes to the forward direction before the recovery time has passed.

The present invention is characterised in that a timer is started at the beginning of a pulse to determine the pulse decay period, and that the thyristor switch element is triggered to conduction when a spark-over in the precipitator is detected during the pulse decay.

This can be achieved by starting a timer running for the duration of a pulse whenever a pulse occurs, detecting the slope of the voltage across the load as a function of time and triggering the thyristor to conduction if the slope of the load voltage function exceeds a preset positive value at a moment when the timer is running.

In an energy conserving system of the above kind the protection of the thyristor may be obtained by sensing the pulse current, which consists of a negative half-period and a positive half-period, and triggering the thyristor to conduction when a shift to negative occurs during the normally positive half-period.

For both principles described the extraordinary firing should take place sufficiently fast following the spark-over. Experience has shown that the time interval between spark-over and firing should preferably not exceed 15 µs, and it is profitably kept below 2 µs.

The invention will now be described further in connection with a precipitator, reference being made to the accompaning drawings, in which:—

Figures 1 and 2 show electrical circuits for feeding an electrostatic precipitator with pulse superimposed on an operating DC-voltage.

Figure 3 shows a graphic depiction of the precipitator voltage as a function of time;

Figure 4 shows, on an enlarged time scale, a graphic depiction of the superimposed precipitator voltage and current during a pulse,

Figure 5 shows in block diagram form a circuit for extraordinary firing of the thyristors;

Figure 6 shows another circuit for extraordinary firing of the thyristors;

Figure 7 shows the pulse current during a pulse when a spark-over occurs during pulse decay; and

Figure 8 shows the current induced by the current of Figure 7 in an auxiliary winding of a saturation reactor in the pulse circuit.

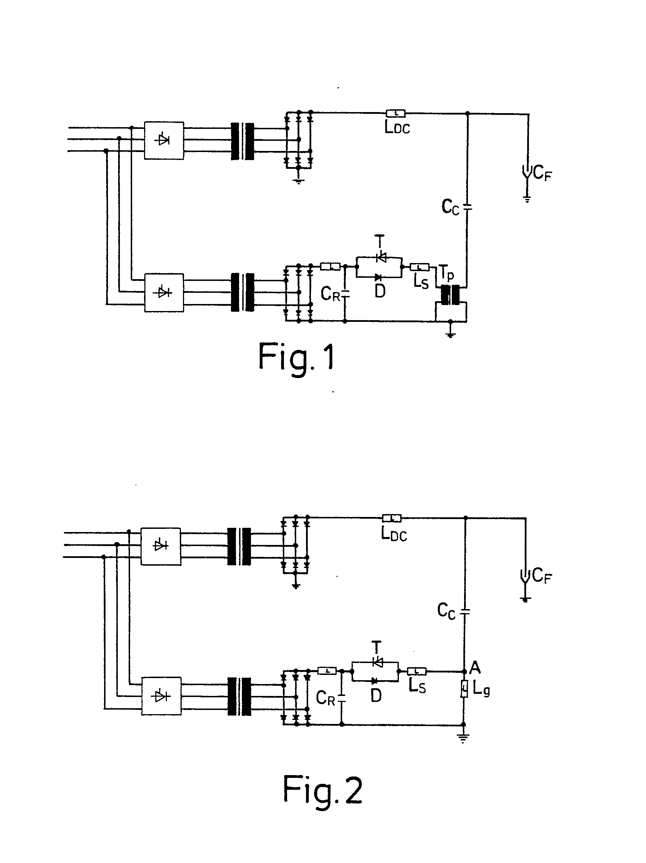

Figures 1 and 2 show, schematically, circuits for energizing an electrostatic precipitator $C_F$ with pulses superimposed on an operating DC-voltage, the pulse generator being of the energy conserving kind described in the GB—A—1,544,105.

In Figure 1 the pulse circuit is shown to consist of a charger supplying a storage capacitor $C_R$, a switch element comprising a thyristor T and a diode D coupled anti-parallel to the thyristor T, a series inductance $L_S$ connected to the precipitator through a pulse transformer $T_P$, and a coupling

capacitor, $C_C$ which blocks the DC supply voltage from the pulse transformer, a blocking inductance $L_{DC}$ preventing the pulse voltage from entering the supply. The storage capacitor $C_R$, the series inductance $L_S$ together with the pulse transformer leakage inductance, the coupling capacitor $C_C$ and the precipitator capacitance $C_F$ form a series oscillatory circuit. In this case the maximum switch voltage level can be selected freely from the maximum precipitator pulse peak voltage by selection of the voltage ratio of the pulse transformer.

In Figure 2 the pulse transformer is replaced by the inductance $L_g$. This inductance serves to keep point A grounded in respect to DC, but isolated from ground for the frequencies in the pulse voltage. In this case the maximum switch voltage level is tied to the maximum precipitator pulse peak voltage through the precipitator capacitance and the choice of the capacitors $C_R$ and $C_C$.

In the latter case the maximum switch voltage level is about half of the maximum precipitator pulse peak voltage. In the first case the maximum switch voltage level might be selected between 1/50 and 1/5 of the maximum pulse peak voltage based on a technical-economic optimization.

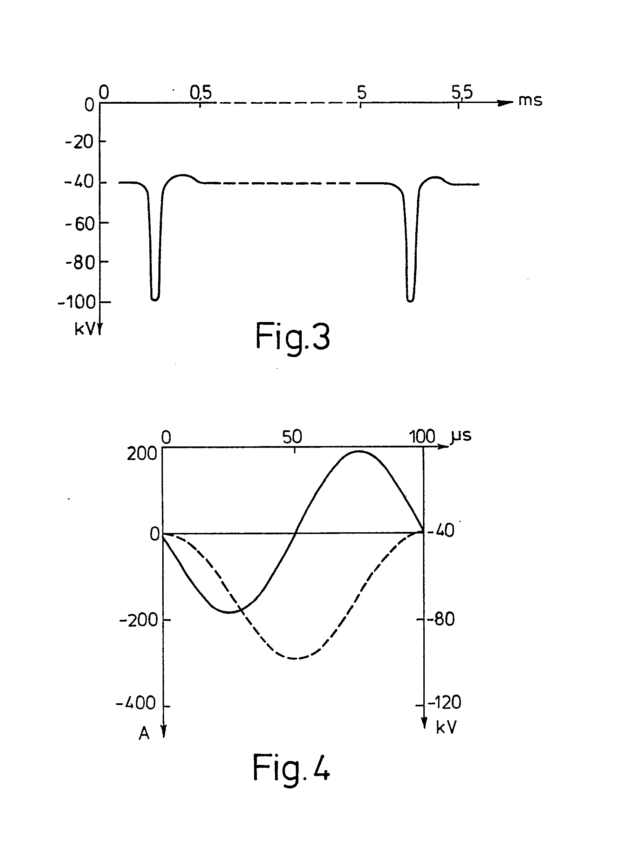

Figure 3 shows the general voltage waveform produced by the circuits in Figures 1 and 2.

Short-duration high voltage pulses are repeatedly superimposed on an operating DC voltage. The pulse duration is within the range 50—200 μs and pulse repetition frequencies from 25—400 Hz are used.

The pulse circuits of Figure 1 and Figure 2 operate in the same manner. The only difference is in the maximum switch voltage level as described above, which is also the maximum charging voltage of the storage capacitor $C_R$.

Storage capacitor $C_R$ is charged to a controlled $D_C$ level by the charger, and when a pulse is to be produced, the thyristor switch is turned on, and the precipitator represented by the capacitance $C_F$ is charged to the peak pulse voltage during the first half period of the oscillatory current by a negative current flowing through the capacitor $C_R$, the thyristor T, the series inductance $L_S$ together with the pulse transformer leakage inductance (equal to zero for the circuit of Figure 2), the coupling capacitor $C_C$, and the precipitator capacitance $C_F$ (see Figure 4). Because of the series oscillation, the energy supplied to capacitance $C_F$ is returned to storage capacitance $C_R$ through the feedback diode D by the current in the second half-period. During this interval, the thyristor is turned off, recovering its hold-off strength, and then the current in the pulse circuit is blocked after the second half-period of the current, until the next ignition of the thyristor switch. For a circuit without energy consumption the amplitudes of the two half-periods are equal and the precipitator voltage is brought back to its original DC level.

A thyristor switch-element may consist of several modules of thyristors, each with an anti-parallel diode, connected in series. In some cases a number of strings of modules are connected in parallel to increase the maximum current limit of the switch element.

The thyristors may be turned on by a cable firing system. In this case a unipolar, fast rising, high current pulse is fed through a cable conductor, forming the primary winding for a number of ring-core pulse current transformers. The secondary winding of these transformers is connected to the gate circuit of each thyristor. The high current pulse in the cable is supplied by a current generator that is triggered by repetitive trigger signals in accordance with the desired pulse frequency.

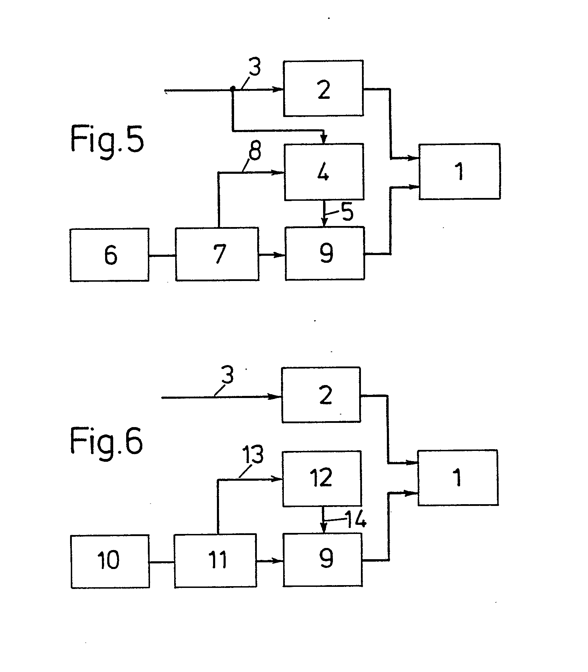

According to the invention an extraordinary triggering of the thyristor(s) should take place whenever a spark-over in the precipitator occurs during a pulse to prevent current overload of the recovering thyristor. (Extraordinary firing for a sparkover during the whole pulse period has been chosen only for circuit simplicity. Obviously, a firing in the on-state situation of the first half period of the pulse is not necessary). Such an extraordinary triggering is obtained by the circuit shown as a block diagram in Figure 5.

The block 1 designates the thyristor firing transmitter which may be a firing cable such as the one described above or another device securing a simultaneous firing of all the thyristors. The firing transmitter 1 is energized from a firing circuit 2 when this circuit receives a trigger signal on its input line 3. These trigger signals come from a trigger signal generator with a repetition frequency according to the desired pulse frequency.

The trigger signals are further fed to a timer circuit 4 and each trigger signal starts the timer running for the duration of one pulse so that a signal on the timer output line 5 indicates that a pulse is occurring.

The precipitator voltage is sensed by a voltage sensor 6 and a slope detector 7 detects changes in that precipitator voltage. The slope detector 7, in principle, differentiates the output signal from the voltage sensor 6. If a preselected negative slope is detected, which indicates that the precipitator voltage rapidly grows more negative it means that a pulse is rising and the slope detector will start the timer circuit through an output line 8. If the pulse is due to the fact that the thyristor has been fired through a trigger signal on the line 3 the timer circuit will be running already but the starting signal on the line 8 will ensure that the timer is also started if the thyristor is unintentionally triggered.

If the slope detector detects a positive slope exceeding a preselected value, which may be e.g. 10 times the maximum value during a normal pulse decay, it means that spark-over is taking place. In this case the slope detector 7 gives off a signal to an extraordinary firing circuit 9 which will fire the thyristors if a signal on the output line 5 from the timer indicates that a pulse is occurring.

The extraordinary firing of the thyristor is shown to be established through an extraordinary firing circuit 9. The emergency firing could of course be established through the normal firing circuit 2, but it is preferred to use a special firing circuit which is maintained in a stand-by situation for this purpose. In this manner a fully charged firing circuit is always available for the extraordinary firing.

Another circuit for obtaining an extraordinary triggering of the thyristors in case of spark-overs during a pulse is shown in block diagram form in Figure 6.

According to this embodiment the occurrence of a pulse is detected by a current sensor 10 sensing the current in the pulse circuit. This current sensor may suitably consist of a saturable reactor inserted in the pulse circuit. This has the advantage that the saturation reactor besides acting as a current sensor also limits the maximum dI/dt of the pulse circuit. An auxiliary winding on the saturable reactor enables a potential free sensing of the coil current.

The signal from the auxiliary winding is led to a spark-over identification circuit 11.

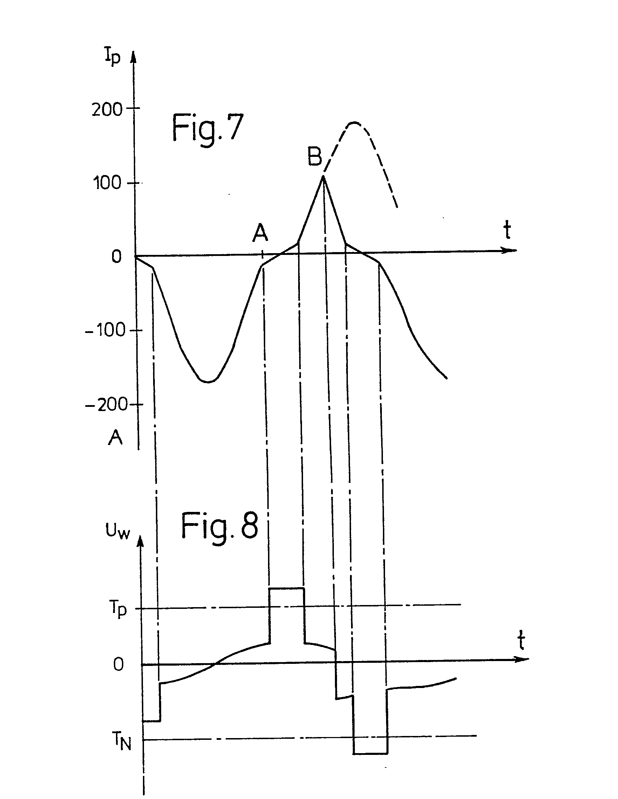

During normal operation without spark-over the current consists of a negative half period followed by a positive one as indicated in Figure 4. If a spark-over occurs during the pulse voltage decay the current of the last half period will change its direction from positive to negative as shown in Figure 7. Figure 8 shows the corresponding voltage $U_W$ across the auxiliary winding.

At the instant marked with A where the voltage from the auxiliary winding exceeds a preselected positive level $T_P$, the spark-over identification circuit will start a timer circuit 12 through an output line 13. The timer will be running for the remaining part of the pulse period so that a signal on the time output line 14 indicates the positive half periods of current. If a spark-over in the precipitator, e.g. at instant B in Figure 7, causes the voltage from the auxiliary winding to exceed a preselected negative level $T_N$ as shown in Figure 8, the spark-over identification circuit 11 gives off a signal to the extraordinary firing circuit 9. This circuit will fire the thyristors through the firing transmitter 1 if a signal on the output line 14 from the timer indicates that the normal pulse current would have been positive.

The above describes only one of several circuits which might be used to detect the change of sign of current indicating the occurrence of a spark-over.

**Claims**

1. A method of protecting a thyristor switch element (T), coupled anti-parallel to diode (D) in an energy recovering pulse generator supplying an electrostatic precipitator (CF), against damage from spark-overs in the precipitator (CF) during a period of pulse decay, characterised in that a timer (4) is started at the beginning of a pulse to determine the pulse decay period, and that the thyristor switch element (T) is triggered to conduction when a spark-over in the precipitator (CF) is detected during the pulse decay.

2. A method according to claim 1, characterised in that a spark-over is detected by measuring the voltage across the precipitator (CF) as a function of time and interpreting it as a spark-over when the slope of the precipitator voltage function exceeds a preset value.

3. A method according to claim 1, characterised in that the current in the pulse generator circuit is supervised and a shift of the current from running in the forward direction of the thyristor switch element (T) to running in the forward direction of the diode (D) is taken as an indication of the beginning of a pulse decay, whereas a shift from running in the forward direction of the diode (D) to running in the forward direction of the thyristor switch element (T) is taken as an indication of the occurrence of a spark-over.

4. An energy conserving pulse generator for supplying an electrostatic precipitator (CF) having a diode (D) coupled anti-parallel to a thyristor switch element (T) and having means for protecting the thyristor switch element (T) from damage caused by spark-over across the precipitator (CF) during a period of pulse decay, characterised in that said means comprises means (4; 10, 11, 12) for determining when a pulse decay occurs; means (6, 7; 10, 11) for detecting the occurrence of a spark-over in the precipitator (CF); and means (9) for triggering the thyristor switch element (T) to conduction when a spark-over occurs during a period of pulse decay.

5. A pulse generator according to claim 4, comprising a timer (4) which is started whenever a pulse starts and runs for the duration of a pulse; means (7) for detecting the slope of the voltage across the precipitator (CF) as a function of time; and means (9) for triggering the thyristor switch element (T) to conduction when the slope of the precipitator voltage function exceeds a preset value at a moment when the timer (4) is running.

6. A pulse generator according to claim 4, comprising a pulse current sensor (10) and an identification circuit (11) which detect the occurrence of a pulse and start a timer (12) running for the duration of a pulse when a current in the pulse generator circuit starts, detect the beginning of a pulse decay when the pulse current changes its direction, and detect a spark-over if the pulse current changes its direction once more, and means (9) for triggering the thyristor switch element (T) when a spark-over is detected during the running of the timer (12).

7. A pulse generator according to claim 6, characterised in that the current sensor (10) is a saturable reactor inserted in the pulse generator circuit and having an auxiliary winding in which the signals indicating the start of a pulse, the start of the pulse decay and the occurrence of a spark-over during the decay are induced.

**Patentansprüche**

1. Verfahren zum Schutz eines Thyristor-Schalterelements (T), das an eine Diode (D) parallel und in entgegengesetzter Richtung in einem Energierückgewinnungsimpulsgenerator angeschlossen ist, der einen elektrostatischen Abscheiber (CF) versorgt, gegen Beschädigung durch Überschläge in dem Abscheider (CF) während eine Periode des Impulsabfalles, dadurch gekennzeichnet, daß ein Zeitnehmer (4) zu Beginn eines Impulses zur Bestimmung der Impulseabfallsperiode in Gang gesetzt wird und daß das Thyristor-Schalterelement (T) zur Leitung angeregt wird, wenn ein Überschlag in dem Abscheiber (CF) während des Impulsabfalles Festgestellt wird.

2. Verfahren nach Anspruch 1, dadurch gekennzeichnet, daß ein Überschlag festgestellt wird, indem die Spannung über dem Ascheider (CF) als eine Funktion der Zeit gemessen wird und indem sie als ein Überschlag interpretiert wird, wenn der Gradient der Abscheiderspannungsfunktion einen zuvor eingestellten Wert überschreitet.

3. Verfahren nach Anspruch 1, dadurch gekennzeichnet, daß der Strom in dem Impulsgeneratorkreis überwacht und ein Übergang des Stroms vom Fließen in Vorwärtsrichtung des Thyristor-Schalterelements (T) zum Fließen in Vorwärtsrichtung der Diode (D) als Anzeichen des Beginns eines Impulsabfalls genommen wird, während ein Übergang vom Fließen in Vorwärtsrichtung der Diode (D) zum Fließen in Vorwärtsrichtungs des Thyristor-Schalterelements (T) als ein Anzeichen für das Auftreten eines Überschlags genommen wird.

4. Energieerhaltungs-Impulsgenerator für die Versorgung eines elektrostatischen Abscheider (CF) mit einer Diode (D), die an ein Thyristor-Schalterelement (T) parallel und in entgegengesetzter Richtung angeschlossen ist, und mit Mitteln zum Schutz des Thyristor-Schalterelements (T) gegen Beschädigung bewirkt durch einen Überschlag über dem Abscheider (CF) wählrend einer Periode des Impulsabfalles, dadurch gekennzeichnet, daß die genannten Mittel über Mittel (4; 10, 11, 12) zur Bestimmung, wann ein Impulsabfall auftritt, über Mittel (6, 7; 10, 11) zur Feststellung des Auftritts eines Überschlags in dem Abscheider (CF) und über Mittel (9) zur Anregung des Thyristor-Schalterelements (T) zur Leitung verfügt, wenn ein Überschlag während einer Periode des Impulsabfalles auftritt.

5. Impulsgenerator nach Anspruch 4, gekennzeichnet, durch einen Zeitnehmer (4), der in Gang gesetzt wird, immer wenn ein Impuls beginnt, und der während der Dauer des Impulses läuft; durch Mittel (7) zur Feststellung des Gradienten der Spannung über dem Abscheider (CF) als eine Funktion der Zeit; und durch Mittel (9) zur Anregung des Thyristor-Schalterelements (T) zur Leitung, wenn der Gradient der Abscheiderspannungsfunktion einen zuvor eingestellten Wert in einem Augenblick überschreitet, wenn der Zeitnehmer (4) läuft.

6. Impulsgenerator nach Anspruch 4, gekennzeichnet durch einen Impulsstromfühler (10) und einem Identifizierungskreis (11), die das Auftreten eines Impulses feststellen und einen Zeitnehmer (12) in Gang setzen, der während der Dauer eines Impulses läuft, wenn ein Strom in dem Impulsgenerator beginnt, die den Beginn eines Impulsabfalles feststellen, wenn der Impulsstrom seine Richtung ändert, und die einen Überschlag feststellen, wenn der Impulsstrom seine Richtung ein weiteres Mal ändert, und durch Mittel (9) zur Anregung des Thyristor-Schalterelements (T), wenn ein Überschlag während des Laufs des Zeitnehmers (12) festgestellt wird.

7. Impulsgenerator nach Ansprüch 6, dadurch gekennzeichnet, daß der Stromfühler (10) ein sättigbarer Reaktor ist, der in dem Impulsgeneratorkreis eingesetzt ist und eine Hilfswicklung aufweist, in der die Signale, die den Beginn eines Impulses, den Beginn des Impulsabfalls und das Auftreten eines Überschlags während des Abfalls anzeigen, induziert werden.

**Revendications**

1. Procédé de protection d'un élément de commutation à thyristor (T), couplé à une diode (D) en parallèle mais en sens inverse dans un générateur d'impulsions à régénération d'énergie, alimentant un précipitateur électrostatique (CF), contre les détériorations dues aux décharges disruptives dans le précipitateur (CF) pendant une période de décroissance d'impulsion, caractérisé en ce qu'une minuterie (4) est mise en route au début d'une impulsion afin qu'elle détermine la période de décroissance d'impulsion, et en ce que l'élément de commutation à thyristor (T) est déclenché à l'état conducteur lorsqu'une décharge disruptive dans le précipitateur (CF) est détectée pendant la décroissance d'impulsion.

2. Procédé selon la revendication 1, caractérisé en ce qu'une décharge disruptive est détectée par mesure de la tension au bornes du précipitateur (CF) en fonction du temps et par interprétation de celle-ci sous forme d'une décharge disruptive lorsque la pente de la fonction de tension du précipitateur dépasse une valeur prérégelée.

3. Procédé selon la revendication 1, caractérisé en ce que le courant dans le circuit générateur d'impulsions est supervisé et un déplacement du courant du sens direct de l'élément de commutation à thyristor (T) au sens direct de la diode (D) est considéré comme une indication du début d'une décroissance d'impulsion, alors qu'un passage du sens direct de la diode (D) au sens direct de l'élément de commutation à thyristor (T) est considéré comme une indication de l'apparition d'une décharge disruptive.

4. Générateur d'impulsions à conservation d'énergie destiné à alimenter un précipitateur électrostatique (CF) ayant une diode (D) montée en parallèle mais en sens inverse par rapport à un élément de commutation à thyristor (T) et ayant un dispositif de protection de l'élément de commuttaion à thyristor (T) contre les détériorations provoquées par une décharge disruptive aux bornes du précipitateur (CF) pendant une période de décroissance d'impulsion, caractérisé en ce que ledit dispositif comporte un dispositif (4; 10, 11, 12) destiné à déterminer le moment d'une décroissance d'impulsion, un dispositif (6, 7; 10, 11) destiné à détecter l'apparition d'une décharge disruptive dans le précipitateur (CF), et un dispositif (9) destiné à déclencher l'élément de commutation à thyristor (T) à l'état conducteur lorsqu'une décharge disruptive a lieu dans une période de décroissance d'impulsion.

5. Générateur d'impulsions selon la revendication 4, comprenant une minuterie (4) qui est mise en route chaque fois qu'une impulsion commence et qui fonctionne pendant la durée d'une impulsion, un dispositif (7) destiné à détecter la pente de la tension appliquée au précipitateur (CF) en fonction du temps, et un dispositif (9) destiné à déclencher l'élément de commutation à thyristor (T) à l'état conducteur lorsque la pente de la fonction de tension du précipitateur dépasse une valeur préréglée au moment où la minuterie (4) fonctionne.

6. Générateur d'impulsions selon la revendication 4, comprenant un capteur de courant pulsé (10) et un circuit d'identification (11) qui détectent l'apparition d'une impulsion et mettent en route une minuterie (12) qui fonctionne pendant la durée d'une impulsion lorsqu'un courant dans le circuit générateur d'impulsions commence, qui détectent le début d'une décroissance d'impulsion lorsque le courant pulsé change de sens, et qui détectent une décharge disruptive lorsque le courant pulsé change de sens, une fois de plus, et un dispositif (9) destiné à déclencher l'élément de commutation à thyristor (T) lorsqu'une décharge disruptive est détectée pendant le fonctionnement de la minuterie (12).

7. Générateur d'impulsions selon la revendication 6, caractérisé en ce que le capteur de courant (10) est un enroulement saturable introduit dans le circuit générateur d'impulsions et ayant un enroulement auxiliaire dans lequel les signaux indiquant le début d'une impulsion, le début de la décroissance d'impulsion et l'apparition d'une décharge disruptive pendant la décroissance sont induits.

Fig. 1

Fig. 2

Fig.3

Fig.4

Fig.5

Fig.6

Fig. 7

Fig. 8